# EUROPÄISCHE PATENTSCHRIFT

(11) **EP 0 835 184 B1**
(45) Veröffentlichungstag und Bekanntmachung des Hinweises auf die Patenterteilung: **06.10.1999**
(21) Anmeldenummer: 96920703.4
(22) Anmeldetag: 26.06.1996
(51) Int. Cl.: B41M 1/18, G03F 3/00

(54) **VERFAHREN ZUM BEDRUCKEN EINES GEGENSTANDES SOWIE HIERDURCH ERHÄLTLICHER FUSSBODENBELAG**
PROCESS FOR PRINTING OBJECTS AND A FLOOR COVERING OBTAINABLE WITH SAID PROCESS
PROCEDE PERMETTANT D'IMPRIMER UN OBJET ET REVETEMENT DE SOL REALISE A L'AIDE DUDIT PROCEDE

(30) Priorität: 26.06.1995 DE 19523188
(43) Veröffentlichungstag der Anmeldung: 15.04.1998
(73) Patentinhaber: DLW Aktiengesellschaft, D-74319 Bietigheim-Bissingen (DE)
(72) Erfinder: LORCH, Erhard, D-71543 Wüstenrot (DE)
(74) Vertreter: Rutetzki, Andreas, Dipl.-Ing.
(86) Internationale Anmeldenummer: DE9601128
(87) Internationale Veröffentlichungsnummer: WO9701445

(56) Entgegenhaltungen:
- DE-A- 3 408 322
- DE-A- 4 417 449

## Beschreibung

Die vorliegende Erfindung betrifft ein Verfahren zum Bedrucken eines Gegenstandes, insbesondere eines Fußbodenbelages, auf der Grundlage von Farbauszügen eines Drei- oder Vierfarbsatzes von einer Druckvorlage.

Das Bedrucken von Bodenbelägen erfolgt bislang mittels des Tiefdruckverfahrens im Sonderfarbraum. Unter Sonderfarben werden generell Mischungen aus Primärfarben, Sekundärfarben, Schwarz und Weiß, also z.B. Beige, Braun, Violett, etc. verstanden. Da es häufig gewünscht ist, daß das Dessin dem Aussehen bestimmter natürlicher Produkte (Marmor, Granit, etc.) entspricht, wird zunächst in aller Regel der gewünschte natürliche Stoff reproduziert (beispielsweise durch Reproduktionsfotografie). Auf der Grundlage dieser Druckvorlage werden anschließend - meist in Absprache mit dem Tiefdruckgraveur - Farbauszüge im Sonderfarbraum in Form von Halbtonopalen erstellt. Unter einem Farbauszug sollen im vorliegenden Zusammenhang sowohl Halbtonopale als auch Datensätze zur Verwendung in der elektronischen Bildverarbeitung verstanden werden.

Das Erstellen der Farbauszüge im Sonderfarbraum erfordert große Erfahrung. Dazu kommt, daß bei der Proof-Abstimmung alle drei oder vier Farbauszüge zu verändern sind, da eine gewünschte Ergebnisveränderung in aller Regel nicht durch Veränderung nur eines Farbauszuges erzielbar ist. Im übrigen sind, um spätere Neudrucke zu ermöglichen, eine große Anzahl von Daten zu speichern.

Als weiteres Problem kommt hinzu, daß gerade im Bereich der Fußbodenbeläge häufig gewünscht ist, von einem Dessin mehrere unterschiedliche Farbgebungen im Sinne einer Farbreihe zu erhalten, die idealerweise noch untereinander kombinierbar sind. Bei diesen Anforderungen potenzieren sich natürlich die eingangs genannten Probleme bei der Farbauszugerstellung. Denn jeder Farbauszug im Sonderfarbraum wird nach den optischen Farbeindrücken ausgewählt und solange bearbeitet bis eine möglichst große Annäherung an den Entwurf vorhanden ist. Die Sonderfarben müssen dabei austauschbar sein zu den jeweiligen Farbauszügen (Farbreihenerstellung), und eine betriebsbedingte und materialbedingte Passerdifferenz muß möglich sein (z.B. wandert eine 400 cm breite Warenbahn in der Maschine unkontrolliert längs und seitlich aufgrund von Materialverzug, Dickendifferenzen, etc). Durch die empirisch ausgezogenen Sonderfarben ergeben sich beim Übereinanderdruck in der Fläche häufig nicht vorhersehbare Überlagerungen, welche zu Bilderungen in der Fläche führen.

Als weiteres fertigungstechnisches Problem ergibt sich, daß bei jeder Farbstellung in der Regel alle Einzelfarben der jeweiligen Druckwerke gewechselt werden müssen. Hierbei entsteht bei einer Warenbreite von 400 cm pro Farbwerk mindestens fünfzig Kilogramm Restfarbe, die zur Weiterverarbeitung abgefüllt und gelagert werden muß.

Vor diesem Hintergrund besteht das der Erfindung zugrundeliegende Problem darin, ein einfacheres Verfahren zum Bedrucken von Gegenständen anzugeben.

Dieses Problem wird durch ein Verfahren zum Bedrucken eines Gegenstandes gemäß Anspruch 1 gelöst.

Mit dem erfindungsgemäßen Verfahren wird der gesamte Prozeß von der Bearbeitung der Reproaufnahmen bis zur Farbreihenerstellung wesentlich vereinfacht. Für das Reduzieren der Unbuntanteile der Farbauszüge des Dreifarbsatzes unter Erzeugung eines Unbuntauszuges kann auf bekannte Verfahren zurückgegriffen werden. Zum Beispiel ist es aus dem Offset-Druck bekannt, die Buntfarben in den dreifarbigen Tiefen zu reduzieren (Unterfarbenreduzierung) um zu einer Farbersparnis und damit einem schnelleren Maschinenlauf zu kommen. Bevorzugt wird bei der Erfindung die sog. polychromatische Farbrücknahme (PCR) angewandt, bei welcher die neutralen Komponenten in den Farbauszügen durch einen Schwarzauszug ersetzt werden. Mit anderen Worten werden alle Grauwerte vom Licht bis zur Tiefe nicht durch Komplementärfarbenaddition, sondern ausschließlich mit der Druckfarbe Schwarz aufgebaut.

Dieses an sich bekannte Verfahren wird nun bevorzugt bei der Erfindung eingesetzt, um den Bedruckgegenstand mit einer Sonderfarbe zu bedrucken. Unter Sonderfarben werden dabei im Rahmen der vorliegenden Erfindung generell alle Farben und Farbmischungen außer den drei Farben des Dreifarbsatzes von der Druckvorlage verstanden. Dabei wird zunächst von der Reproaufnahme (Druckvorlage) ein Drei- oder Vierfarbsatz erstellt, welcher vorzugsweise die Farbauszüge der Grundfarben Magenta, Cyan und Gelb aufweist. Dies hat insbesondere den Vorzug, daß auf der Grundlage standardisierter Farbräume (z.B. CIELAB) insbesondere bei Anwendung der Digitaltechnik das Farbmanagement erheblich vereinfacht ist.

Da bis auf die eine, auf der Grundlage des Unbuntauszuges zu druckende Sonderfarbe mit den gleichen Grundfarben gearbeitet werden kann, ist es generell möglich, durch geeignete Proof-Verfahren (z.B. mittels eines hochauflösenden Tintenstrahldruckers), gravurfertige Datensätze zur Zylindergravur auch ohne größere Kenntnis von den technischen Randbedingungen des Tiefdrucks zu erstellen. Es hat sich weiterhin gezeigt, daß durch Variierung der nur einen Sonderfarbe beliebige Farbreihen auf der Grundlage des gleichen Dessins erstellt werden können, die zueinander passen.

Für spätere Neudrucke ist eine verhältnismäßig wenig Speicheraufwand erfordernde Ablage der entsprechenden Druckdaten möglich.

Vorzugsweise ergibt sich der Unbuntauszug aus der Summe der Differenzen der ursprünglichen und der veränderten Farbauszüge des Dreifarbsatzes. Dies wird beispielsweise mit der polychromatischen Farbrücknahme (PCR, s.o.) realisiert.

Es hat sich weiterhin gezeigt, daß die besten Ergebnisse erzielt werden, wenn die ursprünglichen Farbauszüge zur Erzeugung des Unbuntauszuges so verändert werden, daß sich eine maximal mögliche Flächendeckungsreduzierung einstellt.

Vorzugsweise wird der Bedruckgegenstand nicht nur auf der Grundlage des Unbuntauszuges und der veränderten Farbauszüge, sondern darüber hinaus auf der Grundlage eines Skelettschwarzauszuges bedruckt, welcher erzeugt wird, indem der Unbuntauszug abgeschwächt wird. Das Skelettschwarz bringt die "Zeichnung'' und erzeugt somit den Eindruck einer größeren "Tiefe".

Vorzugsweise wird der Skelettschwarzauszug gegenüber dem Unbuntauszug um 50 bis 90 Prozent abgeschwächt, so daß der Bedruckgegenstand mit 50 Prozent bis 10 Prozent des tiefsten Schwarzes bedruckt wird. Besonders bevorzugt ist eine Abschwächung des Unbuntauszuges um 70 bis 85 Prozent, so daß der Bedruckgegenstand mit 30 bis 15 Prozent des tiefsten Schwarzes bedruckt wird.

Es hat sich weiterhin gezeigt, daß der Gesamteindruck noch weiter verbessert werden kann, wenn der Skelettschwarzauszug geschärft wird. Unter Schärfen soll in diesem Zusammenhang das Ausblenden der vorhandenen Grauwerte verstanden werden. Idealerweise wird der Skelettschwarzauszug maximal geschärft, so daß dieser Auszug nur Schwarz- und Weißanteile aufweist.

Schließlich hat sich gezeigt, daß zur Anpassung der Grundfarben (der drei Farben des Dreifarbsatzes) an die tatsächlichen Druckverhältnisse die Sättigung der veränderten Farbauszüge für den jeweiligen Druckvorgang abgestimmt wird. Hierdurch kann eine ideale Fixierung des Mitteltons in bezug auf Tiefe und Licht erreicht werden.

Zur Reduktion von Passerproblemen (Farbverschiebungen) werden die veränderten Farbauszüge mit Vorteil entschärft.

Die Erfindung wird nachstehend anhand eines Ausführungsbeispiels unter Bezugnahme auf die einzige **Figur** beschrieben.

Zur Erstellung von gravurfertigen Datensätzen zur Zylindergravur für das Bedrucken von Kunststoffbodenbelagsbahnen im Tiefdruck wird gemäß einer Ausführungsform der Erfindung folgendermaßen vorgegangen.

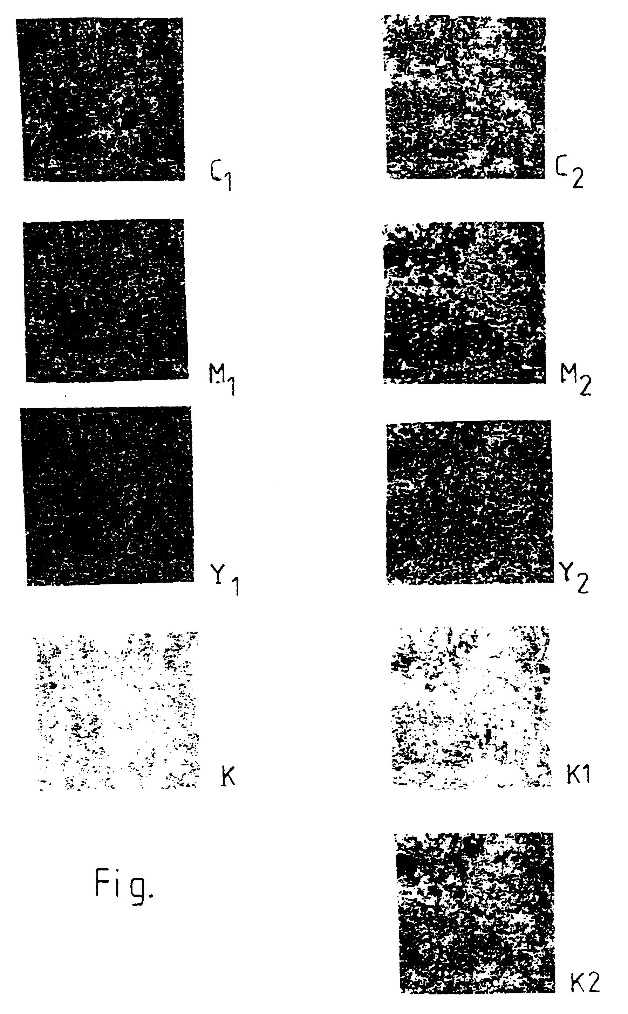

Ausgegangen wird von einem digitalen Vierfarbsatz C₁M₁Y₁K von einer Druckvorlage, welche im Rahmen eines Standard-Farbraumes definiert ist (z.B. CIELAB). Dieser digitale Vierfarbsatz, bestehend aus jeweils einem Auszug für Cyan, Magenta, Gelb und Schwarz, kann auf die verschiedensten Arten erhalten werden. Zum einen kann der Vierfarbsatz erhalten werden durch eine digitale Aufnahme eines künstlerischen Entwurfes oder einer natürlichen Vorlage (z.B. einer Marmorplatte). Mittels elektronischer Bildverarbeitung können an dieser digitalen Aufnahme die verschiedensten Manipulationen wie Positionieren, Retuschieren, Rapporterstellung, etc. vorgenommen werden. Anschließend werden die so manipulierten Daten in den CIELAB-Farbraum unter Erhalt der Farbauszüge C₁M₁Y₁K konvertiert. Alternativ kann ein Design auch ohne Reproduktion digital direkt am Computer erzeugt und schließlich in den CIELAB-Farbraum konvertiert werden. Beispiele eines derart erhaltenen Vierfarbsatzes C₁M₁Y,K im CIELAB-Farbraum sind auf der linken Seite in der Figur dargestellt.

Anschließend wird auf die Farbauszüge C₁M₁Y₁ des Vierfarbsatzes ein Algorithmus zur polychromatischen Farbrücknahme (PCR) angewandt, bei welchem die Unbuntanteile der einzelnen Farbauszüge, ggf. auch nur eines Farbauszuges, falls die anderen Farbauszüge keine Unbuntanteile enthalten) "extrahiert'' und in einem Unbuntauszug K2 zusammengefaßt werden. Der Unbuntauszug K2 stellt somit die Summe der Differenzen der ursprünglichen Farbauszüge C₁M₁Y₁ und der veränderten Farbauszüge C₂M₂Y₂ dar.

Im folgenden wird der Unbuntauszug K2 unter Erzeugung eines Skelettschwarzauszuges K1 abgeschwächt. Schließlich werden die Farbauszüge C₂M₂Y₂ stark entschärft, und der Unbuntauszug K2 und der Skelettschwarzauszug K1 werden geschärft.

Die so erhaltenen Auszüge C₂M₂Y₂K1K2 sind in der Figur auf der rechten Seite dargestellt.

Anschließend erfolgt die Proof-Abstimmung mittels einer geeigneten Proof-Maschine, z.B. einem Tintenstrahldrucker (IRIS). Der Proof erfolgt für die Auszüge C₂M₂Y₂ und K1 mit den Farben Cyan, Magenta, Gelb und Schwarz; für den Auszug K2 wird empirisch eine Sonderfarbe ermittelt, die zu einer bestmöglichen Reproduktion des ursprünglich angestrebten Designs führt.

Somit kann durch Variation nur einer Sonderfarbe ein gewünschtes Dessin leicht ermittelt werden. Die so erhaltenen Datensätze können in definierten Formaten (z.B. TIFF) abgespeichert werden und anschließend als Grundlage für die verschiedensten Druckverfahren wie Tiefdruck, Offset-Druck, aber auch zur Direktbebilderung (Digital Printing) verwendet werden.

Zur Erstellung von Farbreihen, also einer Reihe von Dessins auf der Grundlage des gleichen Grunddessins, jedoch mit verschiedenen Einfärbungen (Colorits) wird genauso vorgegangen wie bei der Proof-Abstimmung zur Ermittlung der idealen Reproduktion. Die für die jeweilige Einfärbung geeignete Sonderfarbe wird empirisch ermittelt. Die Erstellung einer Farbreihe mit verschiedenen Colorierungen, die "zueinander passen", ist aufgrund der Veränderung nur eines Parameters (der Sonderfarbe) überaus einfach. Auch die Abspeicherung der notwendigen Daten für einen etwaigen Neudruck ist mit geringem Speicheraufwand möglich (vgl. oben).

Zu erwähnen ist noch, daß bei der Proof-Abstimmung zur Ermittlung der idealen Reproduktion als auch zur Ermittlung der Colorits die aufgrund der Unbuntanteilreduktion veränderten Farbauszüge C₂M₂Y₂ in ihrer Sättigung veränderbar sind, um Anpassungen an die tatsächlichen Druckverhältnisse vornehmen zu können.

Die so ermittelten Datensätze (die jeweils digital abgespeicherten Farbauszüge C₂M₂Y₂K1K2 sowie die jeweils definierte Sonderfarbe) sind "gravurfertige" Datensätze, d.h. es ist möglich, diese Datensätze direkt zur Gravur von Tiefdruckzylindern für das Bedrucken von Kunststoffbodenbelagsbahnen zu verwenden. Selbstverständlich ist es auch möglich, diese Datensätze für andere Druckverfahren einzusetzen, insbesondere für die in Zukunft an Bedeutung gewinnende Direktbebilderung (digitales Drucken).

## Patentansprüche

1. Verfahren zum Bedrucken eines Gegenstandes gemäß Farbauszügen (C₁M₁Y₁) eines Drei- oder Vierfarbsatzes von einer Druckvorlage, mit den Schritten:
- Reduzieren der Unbuntanteile der Farbauszüge (C₁M₁Y₁) des Farbsatzes unter Erzeugung eines Unbuntauszuges (K2) und entsprechend veränderter Farbauszüge (C₂M₂Y₂),
- Bedrucken des Bedruckgegenstandes auf der Grundlage der veränderten Farbauszüge (C₂M₂Y₂), und
- Bedrucken des Bedruckgegenstandes mit einer von Schwarz verschiedenen Sonderfarbe auf der Grundlage des Unbuntauszuges (K2).

2. Verfahren nach Anspruch 1 wobei der Unbuntauszug (K2) die Summe der Differenzen der ursprünglichen (C₁M₁Y₁) und der veränderten (C₂M₂Y₂) Farbauszüge des Dreifarbsatzes darstellt.

3. Verfahren nach Anspruch 1 oder 2, wobei die ursprünglichen Farbauszüge (C₁M₁Y₁) zur Erzeugung des Unbuntauszuges (K2) so verändert werden, daß sich eine maximal mögliche Flächendeckungsreduzierung einstellt.

4. Verfahren nach einem der Ansprüche 1 bis 3, wobei der Unbuntauszug (K2) unter Erzeugung eines Skelettschwarzauszuges (K1) abgeschwächt wird und der Bedruckgegenstand auf der Grundlage des Skelettschwarzauszuges (K1) mit Schwarz bedruckt wird,

5. Verfahren nach Anspruch 4, wobei der Skelettschwarzauszug (K1) gegenüber dem Unbuntauszug (K2) um 50% - 90% abgeschwächt ist, so daß der Bedruckgegenstand mit 50% - 10% des tiefsten Schwarzes bedruckt wird.

6. Verfahren nach Anspruch 5, wobei der Skelettschwarzauszug (K1) gegenüber dem Unbuntauszug (K2) um 70% - 85% abgeschwächt ist, so daß der Bedruckgegenstand mit 30% bis 15% des tiefsten Schwarzes bedruckt wird.

7. Verfahren nach einem der Ansprüche 4 bis 6, wobei der Skelettschwarzauszug (K1) geschärft wird.

8. Verfahren nach einem der Ansprüche 1 bis 7, wobei der Farbsatz die Farbauszüge der Grundfarben Magenta (M), Cyan (C) und Gelb (Y) aufweist.

9. Verfahren nach einem der Ansprüche 1 bis 8, wobei die Sättigung der veränderten Farbauszüge (C₂M₂Y₂) beim Druckvorgang abgestimmt wird.

10. Verfahren nach einem der Ansprüche 1 bis 9, wobei die veränderten Farbauszüge (C₂M₂Y₂) entschärft werden.

11. Fußbodenbelag, erhältlich gemäß einem Verfahren nach einem der Ansprüche 1 bis 10.

## Claims

1. Process for printing an article in accordance with colour separations (C₁M₁Y₁) of a three-colour or four-colour set from a printing original, having the steps:
- reducing the neutral components of the colour separations (C₁M₁Y₁) of the colour set, while producing a neutral separation (K2) and correspondingly altered colour separations (C₂M₂Y₂),
- printing the article to be printed on the basis of the altered colour separations (C₂M₂Y₂), and
- printing the article to be printed, using a special colour, on the basis of the neutral separation (K2).

2. Process according to Claim 1, wherein the neutral separation (K2) represents the sum of the differences between the original (C₁M₁Y₁) and the altered (C₂M₂Y₂) colour separations of the three-colour set.

3. Process according to Claim 1 or 2, wherein, in order to produce the neutral separation (K2), the original colour separations (C₁M₁Y₁) are altered in such a way that the maximum possible area coverage reduction is established.

4. Process according to one of Claims 1 to 3, wherein the neutral separation (K2) is attenuated, producing a skeleton black separation (K1), and the article to be printed is printed using black on the basis of the skeleton black separation (K1).

5. Process according to Claim 4, wherein the skeleton black separation (K1) is attenuated by 50% - 90% with respect to the neutral separation (K2), with the result that the article to be printed is printed with 50% - 10% of the deepest black.

6. Process according to Claim 5, wherein the skeleton black separation (K1) is attenuated by 70% - 85% with respect to the neutral separation (K2), with the result that the article to be printed is printed with 30% to 15% of the deepest black.

7. Process according to one of Claims 4 to 6, wherein the skeleton black separation (K1) is made sharper.

8. Process according to one of Claims 1 to 7, wherein the colour set has the colour separations of the primary colours magenta (M), cyan (C) and yellow (Y).

9. Process according to one of Claims 1 to 8, wherein the saturation of the altered colour separations (C₂M₂Y₂) is adapted during the printing operation.

10. Process according to one of Claims 1 to 9, wherein the altered colour separations (C₂M₂Y₂) are made less sharp.

11. Floor covering, obtainable in accordance with a process according to one of Claims 1 to 10.

## Revendications

1. Procédé d'impression d'un objet selon les extraits de couleur (C₁M₁Y₁) d'une gamme de trois ou de quatre couleurs provenant d'un original d'impression, comprenant les étapes :
- de réduction des fractions achromatiques des extraits de couleur (C₁M₁Y₁) de la gamme de couleurs en générant un extrait achromatique (K2) et en correspondance des extraits modifiés de couleur (C₂M₂Y₂),
- d'impression de l'objet à imprimer sur la base des extraits modifiés de couleur (C₂M₂Y₂) et
- d'impression de l'objet à imprimer à l'aide d'une couleur spéciale différente du noir sur la base de l'extrait achromatique (K2).

2. Procédé selon la revendication 1, suivant lequel l'extrait achromatique (K2) représente la somme des différences des extraits initiaux (C₁M₁Y₁) et modifiés (C₂M₂Y₂) des couleurs de la gamme de trois couleurs.

3. Procédé selon la revendication 1 ou 2, suivant lequel les extraits initiaux de couleur (C₁M₁Y₁) sont modifiés pour la génération de l'extrait achromatique (K2) de manière qu'il se produise une réduction maximale possible de la couverture de surface.

4. Procédé selon l'une des revendications 1 à 3, suivant lequel l'extrait achromatique (K2) est affaibli avec génération d'un extrait de squelette de noir (K1) et l'objet à imprimer est imprimé sur la base de l'extrait de squelette de noir (K1) avec du noir.

5. Procédé selon la revendication 4, suivant lequel l'extrait de squelette de noir (K1) est affaibli par rapport à l'extrait achromatique (K2) de 50% - 90%, de sorte que l'objet subissant l'impression est imprimé à 50% - 10% du noir le plus profond.

6. Procédé selon la revendication 5, suivant lequel l'extrait de squelette de noir (K1) est affaibli par rapport à l'extrait achromatique (K2) de 70% - 85%, de sorte que l'objet subissant l'impression est imprimé avec de 30% à 15% du noir le plus profond.

7. Procédé selon l'une des revendications 4 à 6, suivant lequel l'extrait de squelette de noir (K1) est intensifié.

8. Procédé selon l'une des revendications 1 à 7, suivant lequel la gamme des couleurs comprend les extraits des couleurs primaires Magenta (M), Cyan (C) et Jaune (J).

9. Procédé selon l'une des revendications 1 à 8, suivant lequel la saturation des extraits modifiés de couleur (C₂M₂Y₂) est mise en concordance lors du processus d'impression.

10. Procédé selon l'une des revendications 1 à 9, suivant lequel les extraits modifiés de couleur (C₂M₂Y₂) sont atténués.

11. Revêtement de sol s'obtenant suivant un procédé selon l'une des revendications 1 à 10.
